# EUROPÄISCHE PATENTSCHRIFT

(11) **EP 3 956 168 B1**
(45) Veröffentlichungstag und Bekanntmachung des Hinweises auf die Patenterteilung: **20.08.2025**
(21) Anmeldenummer: 20733203.2
(22) Anmeldetag: 03.06.2020
(51) Int. Cl.: B60K 35/10

(54) **BETÄTIGUNGSVORRICHTUNG FÜR EIN FAHRZEUG DES ÖFFENTLICHEN PERSONENVERKEHRS**
ACTUATION DEVICE FOR A PUBLIC TRANSPORT VEHICLE
DISPOSITIF D'ACTIONNEMENT POUR UN VÉHICULE DES TRANSPORTS PUBLICS

(30) Priorität: 28.06.2019 DE 102019209522
(43) Veröffentlichungstag der Anmeldung: 23.02.2022
(73) Patentinhaber: Siemens Mobility GmbH, 81739 München (DE); Airbus Operations GmbH, 21129 Hamburg (DE)
(72) Erfinder: BEHLAU, Gregor, 21129 Hamburg (DE); GÄRTNER, Ralph, 41379 Brüggen (DE); HÄUSSLER, Andreas, 42659 Solingen (DE); SCHNEIDER, Christian, 46535 Dinslaken (DE); SCHROCK, Christoph, 21629 Neu Wulmstorf (DE)
(74) Vertreter: Isarpatent
(86) Internationale Anmeldenummer: PCT/EP2020/065260
(87) Internationale Veröffentlichungsnummer: WO 2020/259968

(56) Entgegenhaltungen:
- DE-A1- 102018 122 443
- DE-C1- 3 725 777
- US-A1- 2013 297 251
- ANONYMOUS: "MGC3030/3130 3D Tracking and Gesture Controller Data Sheet. 2019 (DS40001667F)", MICROCHIP TECHNOLOGY INC., 1 January 2019 (2019-01-01), pages 1 - 51, XP055809452, Retrieved from the Internet <URL:http://ww1.microchip.com/downloads/en/DeviceDoc/MGC3030-3130-3D-Tracking-and-Gesture-Controller-40001667F.pdf> [retrieved on 20240611]

## Beschreibung

Die Erfindung betrifft eine Betätigungsvorrichtung für ein Fahrzeug des öffentlichen Personenverkehrs, deren Verwendungen sowie ein Fahrzeug des öffentlichen Personenverkehrs mit einer oder mehreren Betätigungsvorrichtungen.

In Fahrzeugen des öffentlichen Personenverkehrs, insbesondere in Nah- oder Fernverkehrszügen, kommen häufig Betätigungsvorrichtungen zur Ansteuerung von Fahrzeugvorrichtungen, wie zum Beispiel zum Aktivieren eines Türantriebs zum Öffnen bzw. Schließen einer Fahrzeugtür oder zum Betätigen einer Toilettenspülung, zum Einsatz.

Oftmals sind die Betätigungsvorrichtungen als Taster ausgebildet, die von einem Fahrgast per Finger- oder Handflächendruck zu betätigen sind. Problematisch bei derartigen Betätigungsvorrichtungen ist, dass aufgrund des direkten Kontakts der Betätigungsvorrichtungen mit den Fingern bzw. Händen von Fahrgästen Bakterien leicht von einem Fahrgast zu einem anderen Fahrgast übertragen werden können. Um die Bakterienübertragung beim Betätigen von Betätigungsvorrichtungen zu reduzieren, kommen in einigen Fahrzeugen des öffentlichen Personenverkehrs, insbesondere in deren Sanitärräumen, Desinfektionsmittelspender zum Einsatz, mittels welcher Fahrgäste ihre Hände desinfizieren können.

DE 10 2018 122443 A1 beschreibt eine Betätigungsvorrichtung für ein Fahrzeug des öffentlichen Personenverkehrs, welche durch eine vorgegebene berührungslose Betätigungsgeste betätigbar ist, aufweisend eine berührungslos messende Sensoreinheit sowie eine mit der Sensoreinheit verbundene Auswerteeinheit, wobei- die Sensoreinheit dazu eingerichtet ist, ein Sensorsignal zu erzeugen und das Sensorsignal an die Auswerteeinheit zu übermitteln, wenn ein Objekt, insbesondere ein Finger oder eine Hand einer Person, innerhalb eines Erfassungsraums der Sensoreinheit eine Bewegung mit einem Abstand zur Betätigungsvorrichtung ausführt, wobei das Signal vom Bewegungsablauf der Bewegung abhängig ist.

DE 3725777 C1 beschreibt einen Elektro-Druck-Schalter, der beispielsweise an Türen von Nahverkehrszügen in die Wagonwand eingebaut werden kann.

Das Datenblatt "MGCBOBO/3130 3D Tracking and Gesture Controller Data Sheet. 2019" von MICROCHIP TECHNOLOGY INC. (XP055809452) beschreibt Spezifikationen eines Gesten- und Bewegungsnachführungs-Chips oder -Sensors. Unter anderem wird beschrieben, wie Feldlinien eines von dem Sensor emittierten elektrischen Felds durch ein Objekt, wie eine Hand, gestört wird.

US 2013/297251 A1 beschreibt ein System und Verfahren zur Bestimmung einer Position eines Objekts in einem elektrischen Feld.

Der Erfindung liegt die Aufgabe zugrunde, es zu ermöglichen, dass beim Betätigen einer Betätigungsvorrichtung, insbesondere in einem Fahrzeug des öffentlichen Personenverkehrs, eine Übertragung von Bakterien von einer Person zu einer anderen Person vermieden wird.

Diese Aufgabe wird erfindungsgemäß gelöst durch eine Betätigungsvorrichtung nach Anspruch 1, durch ein Fahrzeug nach Anspruch 10 sowie durch Verwendungen nach den Ansprüchen 11, 12, 13 und 14.

Bevorzugte Ausgestaltungen der Erfindung sind Gegenstand der weiteren Patentansprüche sowie der nachfolgenden Beschreibung.

Die erfindungsgemäße Betätigungsvorrichtung für ein Fahrzeug des öffentlichen Personenverkehrs ist durch eine vorgegebene berührungslose Betätigungsgeste betätigbar. Die Betätigungsvorrichtung weist eine berührungslos messende Sensoreinheit sowie eine mit der Sensoreinheit verbundene Auswerteeinheit auf. Besagte Sensoreinheit ist dazu eingerichtet, ein Sensorsignal zu erzeugen und das Sensorsignal an die Auswerteeinheit zu übermitteln, wenn ein Objekt, insbesondere ein Finger oder eine Hand einer Person, innerhalb eines Erfassungsraums der Sensoreinheit eine Bewegung mit einem Abstand zur Betätigungsvorrichtung ausführt, wobei das Signal vom Bewegungsablauf der Bewegung abhängig ist. Ferner ist die Auswerteeinheit dazu eingerichtet, anhand des Sensorsignals zu prüfen, ob die vom Objekt ausgeführte Bewegung eine vorgegebene berührungslose Betätigungsgeste ist, durch welche die Betätigungsvorrichtung betätigbar ist, und, falls die vom Objekt ausgeführte Bewegung eine solche Betätigungsgeste ist, ein Steuersignal für eine zu steuernde Vorrichtung des Fahrzeugs zu erzeugen.

Dadurch, dass die Betätigungsvorrichtung durch eine vorgegebene berührungslose Betätigungsgeste betätigbar, kann darauf verzichtet werden, die Betätigungsvorrichtung zum Zwecke ihrer Betätigung zu berühren. Folglich kann eine Übertragung von Bakterien von einer Person zu einer anderen Person, welche auf einen direkten Kontakt der Betätigungsvorrichtung mit den Fingern bzw. Händen von Personen zurückzuführen ist, vermieden werden.

Fehlauslösungen/-betätigungen der Betätigungsvorrichtung können unter Umständen kritisch sein, beispielsweise wenn die Betätigungsvorrichtung zum Öffnen einer Tür, insbesondere einer Tür eines Sanitärraums, verwendet wird.

Dadurch, dass mithilfe der Sensoreinheit und der Auswerteeinheit geprüft wird, ob die von einem Objekt, wie zum Beispiel einem Finger oder einer Hand einer Person, innerhalb des Erfassungsraums der Sensoreinheit ausgeführte Bewegung, einer vorgegebenen berührungslosen Betätigungsgeste entspricht, können Fehlauslösungen/-betätigungen der Betätigungsvorrichtung vermieden werden. Besagte Prüfung ermöglicht es, sicherzustellen, dass die Betätigungsvorrichtung berührungslos nur dann betätigt wird, wenn die vom Objekt durchgeführte Bewegung einer vorgegebenen berührungslosen Betätigungsgeste entspricht. Insbesondere kann auf diese Weise vermieden werden, dass die Betätigungsvorrichtung durch ein zufällig in den Erfassungsbereich der Sensoreinheit gelangendes Objekt, wie zum Beispiel einen Rucksack einer Person, betätigt wird.

Die Formulierung, dass die Betätigungsvorrichtung durch eine vorgegebene berührungslose Betätigungsgeste betätigbar ist, ist nicht notwendigerweise so zu verstehen, dass die Betätigungsvorrichtung durch eine einzige vorgegebene berührungslose Betätigungsgeste betätigbar ist. Gegebenenfalls kann die Betätigungsvorrichtung durch eine Mehrzahl von vorgegebenen berührungslosen Betätigungsgesten betätigbar sein.

Unter dem Erfassungsraum der Sensoreinheit ist vorliegend ein Raum zu verstehen, innerhalb dessen die Sensoreinheit eine Bewegung eines Objekts berührungslos erfassen kann. Der Erfassungsraum der Sensoreinheit ist nicht notwendigerweise ein einzelner zusammenhängender Bereich. Zum Beispiel kann der Erfassungsraum mehrere nicht zusammenhängende (Teil-)Bereiche umfassen.

Bei der Prüfung, ob die vom Objekt ausgeführte Bewegung eine vorgegebene berührungslose Betätigungsgeste ist, vergleicht die Auswerteeinheit vorzugsweise das Sensorsignal mit einem oder mehreren in der Auswerteeinheit hinterlegten Referenzsignalen, wobei das Referenzsignal bzw. die Referenzsignale (jeweils) einer vorgegebenen Betätigungsgeste zugeordnet ist/sind, durch welche die Betätigungsvorrichtung betätigbar ist. In bevorzugter Weise wird die Bewegung als eine vorgegebene berührungslose Betätigungsgeste eingestuft, durch welche Betätigungsvorrichtung betätigbar ist, wenn das (in Abhängigkeit der Bewegung des Objekts erzeugte) Sensorsignal mindestens einem Referenzsignal entspricht oder innerhalb eines vorgegebenen Toleranzbereichs um ein Referenzsignal liegt.

Durch das zuvor erwähnte Steuersignal, das von der Auswerteeinheit erzeugt wird, wird die zu steuernde Vorrichtung zweckmäßigerweise zur Ausführung einer vorgegebenen Aktion veranlasst.

Besagte Auswerteeinheit umfasst vorteilhafterweise einen Prozessor, insbesondere einen Mikroprozessor, und einen Datenspeicher. Vorzugsweise ist die Auswerteeinheit durch eine im Datenspeicher hinterlegte, vom Prozessor ausführbare Software dazu eingerichtet, die besagte Prüfung und etwaige andere Schritte, insbesondere die nachfolgen beschriebenen Schritte, durchzuführen.

Die Auswerteeinheit kann am gleichen Ort wie die Sensoreinheit angeordnet sein. Alternativ kann die Auswerteeinheit entfernt von der Sensoreinheit angeordnet sein. Des Weiteren können die Auswerteeinheit drahtlos, beispielsweise über eine Funkverbindung, oder kabelgebunden miteinander verbunden sein.

Ferner kann vorgesehen sein, dass die Auswerteeinheit nicht nur zur Auswertung von Sensorsignalen der Betätigungsvorrichtung, sondern auch zur Auswertung von Signalen anderer Vorrichtungen des Fahrzeugs eingerichtet ist. Gegebenenfalls kann die Auswerteeinheit dazu eingerichtet sein, auch für diese anderen Vorrichtungen des Fahrzeugs Steuersignale zu erzeugen.

Im Sinne der vorliegenden Erfindung ist eine vorgegebene berührungslose Betätigungsgeste, durch welche die Betätigungsvorrichtung betätigbar ist, vorzugsweise nicht etwa eine Bewegung, bei der das Objekt, lediglich an die Sensoreinheit herangeführt wird, ohne diese zu berühren, und dann wieder von der Sensoreinheit weggeführt wird. Vorteilhafterweise umfasst eine vorgegebene berührungslose Betätigungsgeste, durch welche die Betätigungsvorrichtung betätigbar ist, zwischen dem Heranführen des Objekts an die Sensoreinheit und dem Wegführen des Objekts von der Sensoreinheit mindestens eine im Abstand zu der Sensoreinheit ausgeführte vorgegebene Bewegungskomponente, wie zum Beispiel ein kreisförmiges oder rechteckförmiges Bewegungsmuster.

Des Weiteren kann die Betätigungsvorrichtung TSI-PRM konform ausgeführt sein. Das heißt, die Betätigungsvorrichtung kann derart ausgeführt sein, dass die Betätigungsvorrichtung den Anforderungen der europäischen Verordnung TSI-PRM genügt.

Bei einer vorteilhaften Ausführungsform der Erfindung weist die Betätigungsvorrichtung eine Taste auf, mittels welcher die Betätigungsvorrichtung durch Druckausübung betätigbar ist. Mithilfe der Taste kann die Betätigungsvorrichtung, falls gewünscht, (alternativ zu einer Betätigung über eine vorgegebene berührungslose Geste) durch Druckausübung mit der Handfläche oder mit einem oder mehreren Fingern betätigt werden. Die Taste kann beispielsweise genutzt werden, falls die Sensoreinheit der Betätigungsvorrichtung defekt ist oder falls eine Person, aus irgendeinem Grund nicht in der Lage ist, die Betätigungsvorrichtung durch eine vorgegebene Betätigungsgeste zu betätigen.

In bevorzugter Weise umgibt die Sensoreinheit der Betätigungsvorrichtung zumindest einen Teilbereich der Taste.

Die Betätigungsvorrichtung ist vorteilhafterweise dazu eingerichtet, bei Druckausübung auf die Taste ein Steuersignal für die zu steuernde Vorrichtung des Fahrzeugs zu erzeugen. Hierbei kann es sich insbesondere um das gleiche Steuersignal wie im Falle einer Betätigung der Betätigungsvorrichtung über eine berührungslose Betätigungsgeste handeln.

Ferner kann die Taste mit einem Piktogramm, insbesondere einem erhabenem Piktogramm, versehen sein. Das Piktogramm gibt zweckmäßigerweise die Funktion der Betätigungsvorrichtung bildlich wieder. Falls die Betätigungsvorrichtung zum Aktivieren eines Türantriebs dient, kann das Piktogramm zum Beispiel eine nach links gerichtete Pfeilspitze sowie eine nach rechts gerichtete Pfeilspitze umfassen. Dient die Betätigungsvorrichtung hingegen zum Aktivieren eines Händetrockners, kann das Piktogramm zum Beispiel mehrere geschwungene Pfeile umfassen, die einen Luftstrom symbolisieren.

Es ist vorteilhaft, wenn sich der Erfassungsraum der Sensoreinheit bis zu einer Entfernung von höchstens 10 cm, vorzugsweise höchstens 7 cm, besonders bevorzugt höchstens 5 cm, von der Betätigungsvorrichtung erstreckt. In dem Fall, dass die Erstreckung des Erfassungsraums der Sensoreinheit einstellbar ist, ist die Maximal-Erstreckung des Erfassungsraums vorteilhafterweise auf einen der zuvor genannten Werte eingestellt.

Die Sensoreinheit umfasst mehrere nebeneinander angeordnete, berührungslos messende Sensoren, welche insbesondere äquidistant zueinander angeordnet sein können. Die Sensoreinheit kann beispielsweise mindestens 6 Sensoren, vorzugsweise mindestens 8 Sensoren, besonders bevorzugt mindestens 10 Sensoren, umfassen.

Jeder der Sensoren der Sensoreinheit weist vorteilhafterweise einen eigenen Erfassungsbereich auf. Der Erfassungsraum der Sensoreinheit setzt sich aus den Erfassungsbereichen der einzelnen Sensoren zusammen.

Unter dem Erfassungsbereich eines Sensors der Sensoreinheit ist vorliegend ein Bereich zu verstehen, innerhalb dessen der jeweilige Sensor eine Bewegung eines Objekts berührungslos erfassen kann.

Die Erfassungsbereiche der Sensoren können sich berühren oder überlappen. In diesem stellt der Erfassungsraum der Sensoreinheit einen einzelnen zusammenhängenden Bereich dar. Alternativ können die Erfassungsbereiche der Sensoren voneinander beabstandet sein. In letztgenanntem Fall ist der Erfassungsraum der Sensoreinheit kein einzelner zusammenhängender Bereich, sondern umfasst mehrere nicht zusammenhängende Teilbereiche.

Vorteilhafterweise ist der jeweilige Sensor dazu eingerichtet, ein Signal zu erzeugen, wenn das Objekt durch seinen Erfassungsbereich geführt wird. Das zuvor erwähnte Sensorsignal, das von der Sensoreinheit erzeugt wird, basiert vorzugsweise auf den von den einzelnen Sensoren erzeugten Signalen.

Des Weiteren kann die Auswerteeinheit dazu eingerichtet sein, die Bewegung des Objekts auch dann als eine vorgegebene berührungslose Betätigungsgeste einzustufen, durch welche die Betätigungsvorrichtung betätigbar ist, wenn nicht jeder der Sensoren der Sensoreinheit einen Durchtritt des Objekts durch seinen Erfassungsbereich detektiert.

Die Situation, dass nicht jeder der Sensoren einen Durchtritt des Objekts durch seinen Erfassungsbereich detektiert, kann beispielsweise dann vorliegen, wenn das Objekt (versehentlich) nicht durch den Erfassungsbereich eines Sensors bzw. nicht durch die Erfassungsbereiche mehrerer Sensoren geführt wird oder wenn ein oder mehrere Sensoren defekt sind und somit ein Durchtritt durch den jeweiligen Erfassungsbereich nicht erfasst werden kann.

Vorzugsweise ist die Auswerteeinheit derart eingerichtet, dass die Bewegung des Objekts von der Auswerteeinheit nur dann als eine vorgegebene berührungslose Betätigungsgeste eingestuft wird, durch welche die Betätigungsvorrichtung betätigbar ist, wenn mindestens ein Drittel der Sensoren der Sensoreinheit, vorzugsweise mindestens die Hälfte der Sensoren der Sensoreinheit, einen Durchtritt des Objekts durch seinen jeweiligen Erfassungsbereich detektiert. Dadurch kann von der Auswerteeinheit mit hinreichender Genauigkeit bzw. Sicherheit ermittelt werden, ob die vom Objekt ausgeführte Bewegung eine vorgegebene berührungslose Betätigungsgeste ist, durch welche die Betätigungsvorrichtung betätigbar ist.

Ferner kann die Auswerteeinheit derart eingerichtet sein, dass die Bewegung des Objekts nur dann als eine vorgegebene berührungslose Betätigungsgeste eingestuft wird, durch welche die Betätigungsvorrichtung betätigbar ist, wenn die Zeitspanne, innerhalb dessen die Bewegung erfolgt, eine vorgegebene Zeitspanne, von beispielsweise 5 Sekunden, nicht überschreitet.

Die Sensoren der Sensoreinheit können beispielsweise kreisförmig nebeneinander angeordnet sein. In diesem Fall ist die Betätigungsvorrichtung zweckmäßigerweise über eine kreisförmige oder im Wesentlichen kreisförmige Betätigungsgeste betätigbar.

Weiterhin kann die Auswerteeinheit derart eingerichtet sein, dass die Bewegungsrichtung der Betätigungsgeste beliebig ist. Dadurch kann zum Beispiel sowohl eine im Uhrzeigersinn ausgeführte Bewegung des Objekts als auch eine im Gegenuhrzeigersinn ausgeführte Bewegung des Objekts als eine vorgegebene berührungslose Betätigungsgeste eingestuft werden, durch welche die Betätigungsvorrichtung betätigbar ist.

Bei einer bevorzugten Ausgestaltung der Erfindung sind die Sensoren der Sensoreinheit Infrarotsensoren. Derartige Sensoren haben eine gute Messempfindlichkeit, sind robust und sind zudem kostengünstig erhältlich. Alternativ kann es sich bei den Sensoren der Sensoreinheit beispielsweise um kapazitive Sensoren handeln.

Die Betätigungsvorrichtung kann ferner eine mit der Sensoreinheit verbundene Visualisierungsvorrichtung zum Visualisieren des von der Sensoreinheit erfassten Anteils der Bewegung des Objekts aufweisen. Die Visualisierungsvorrichtung ermöglicht es einer Person, bei der Ausführung einer Bewegung im Erfassungsraum der Sensoreinheit visuell zu erkennen, inwieweit die Betätigungsvorrichtung einen bislang ausgeführten Bewegungsanteil der Bewegung erkannt hat.

In bevorzugter Weise umfasst die Visualisierungsvorrichtung mehrere Leuchtvorrichtungen. Die Leuchtvorrichtungen können beispielsweise jeweils die Form eines Ringsegments aufweisen, wobei die Leuchtvorrichtungen insbesondere derart nebeneinander angeordnet sein können, dass die Leuchtvorrichtungen zusammen einen Ring ausbilden. Die jeweilige Leuchtvorrichtung kann zum Beispiel eine oder mehrere Leuchtdioden (LEDs) als Leuchtmittel umfassen.

Es ist vorteilhaft, wenn die Visualisierungsvorrichtung dazu eingerichtet ist, die einzelnen Leuchtvorrichtungen in Abhängigkeit vom Bewegungsablauf der Bewegung des Objekts aufleuchten zu lassen.

Vorzugsweise ist die Visualisierungsvorrichtung dazu eingerichtet, die Leuchtvorrichtungen in Abhängigkeit des von der Sensoreinheit erzeugten Sensorsignals anzusteuern.

Jeder der Leuchtvorrichtungen kann mindestens ein Sensor, insbesondere genau ein Sensor, der Sensoreinheit zugeordnet sein. Die Visualisierungsvorrichtung kann in diesem Fall dazu eingerichtet sein, die jeweilige Leuchtvorrichtung aufleuchten zu lassen, wenn das Objekt durch den Erfassungsbereich eines der jeweiligen Leuchtvorrichtung zugeordneten Sensors der Sensoreinheit geführt wird.

Das erfindungsgemäße Fahrzeug des öffentlichen Personenverkehrs weist eine oder mehrere erfindungsgemäße Betätigungsvorrichtungen auf.

Bei dem Fahrzeug kann es sich beispielsweise um ein Schienenfahrzeug, insbesondere um eine U-Bahn, eine Straßenbahn oder eine Eisenbahn, handeln. Alternativ kann das Fahrzeug zum Beispiel ein Flugzeug, ein Schiff oder Bus sein.

Falls das Fahrzeug mehrere erfindungsgemäße Betätigungsvorrichtungen aufweist, können die Betätigungsvorrichtungen insbesondere unterschiedliche Funktionen haben. Das heißt, die Betätigungsvorrichtungen können insbesondere zur Ansteuerung verschiedener Vorrichtungen des Fahrzeugs genutzt werden.

Zweckmäßigerweise wird das von der jeweiligen Betätigungsvorrichtung bei deren Betätigung erzeugte Steuersignal an die jeweilige zu steuernde Vorrichtung des Fahrzeugs übermittelt. Für die Signalübermittlung kann eine drahtlose Verbindung, insbesondere eine Funkverbindung, oder eine kabelgebundene Verbindung, zum Einsatz kommen.

Bei einer erfindungsgemäßen Verwendung der erfindungsgemäßen Betätigungsvorrichtung ist vorgesehen, die Betätigungsvorrichtung in oder an einem Sanitärraum, wie zum Beispiel einem Toiletten- oder Waschraum, eines Fahrzeugs des öffentlichen Personenverkehrs zu verwenden, insbesondere zum Aktivieren einer Toilettenspülung, zum Aktivieren einer Auslaufarmatur eines Handwaschbeckens, zum Aktivieren eines Händetrockners oder zum Öffnen und/oder Schließen einer Tür des Sanitärraums.

Bei einer weiteren erfindungsgemäßen Verwendung der erfindungsgemäßen Betätigungsvorrichtung in einem Fahrzeug des öffentlichen Personenverkehrs ist vorgesehen, die Betätigungsvorrichtung zum Aktivieren eines Türantriebs zum Öffnen und/oder Schließen einer Fahrzeugeinstiegstür zu verwenden.

Eine andere erfindungsgemäße Verwendung der erfindungsgemäßen Betätigungsvorrichtung in einem Fahrzeug des öffentlichen Personenverkehrs ist die Verwendung der Betätigungsvorrichtung zum Aktivieren eines Klappenantriebs zum Öffnen und/oder Schließen einer Mülleimerklappe.

Der die Mülleimerklappe aufweisende Mülleimer kann sich zum Beispiel in einem Sanitärraum des Fahrzeugs befinden. Alternativ kann sich der Mülleimer in einem anderen Bereich des Fahrzeugs befinden.

Noch eine weitere erfindungsgemäße Verwendung der erfindungsgemäßen Betätigungsvorrichtung in einem Fahrzeug des öffentlichen Personenverkehrs ist die Verwendung der Betätigungsvorrichtung zum Signalisieren eines Haltewunschs.

Es zeigen:
- FIG 1: eine Schnittdarstellung eines Teilabschnitts eines Fahrzeugs, welches mit mehreren Betätigungsvorrichtungen ausgestattet ist;
- FIG 2: eine der Betätigungsvorrichtungen des Fahrzeugs in einer Frontalansicht;
- FIG 3: die Betätigungsvorrichtung aus FIG 2 und eine Hand einer Person, eine vorgegebene berührungslose Betätigungsgeste zur Betätigung der Betätigungsvorrichtung ausführt.

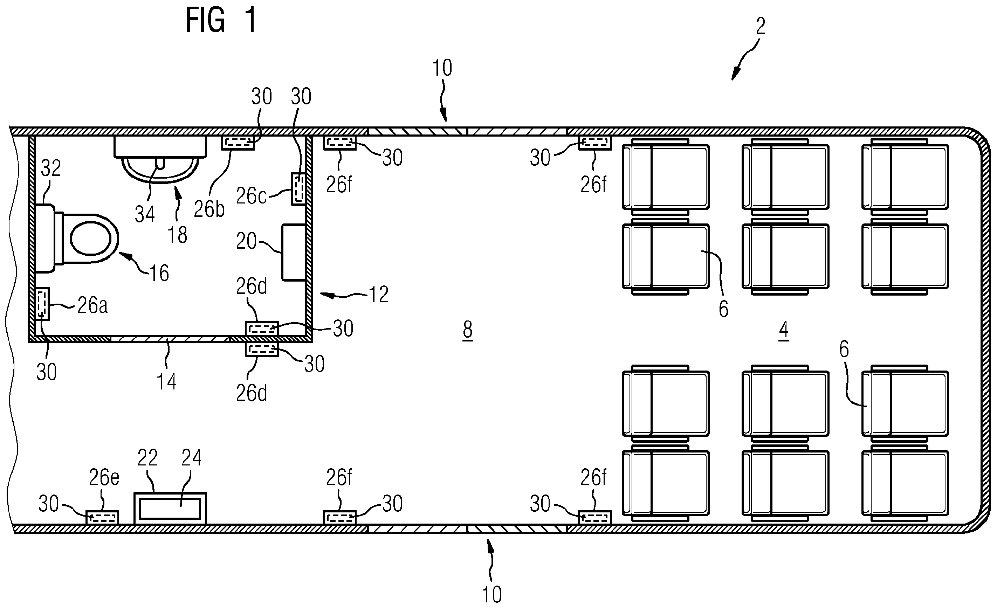

FIG 1 zeigt einen Teilbereich eines Fahrzeugs 2 des öffentlichen Personenverkehrs in einer Schnittdarstellung. Im vorliegenden Ausführungsbeispiel handelt es sich bei dem Fahrzeug 2 insbesondere um ein Schienenfahrzeug.

In FIG 1 sind ein Sitzplatzbereich 4 mit mehreren Fahrgastsitzen 6, ein Ein-/Ausstiegsbereich 8 mit zwei einander gegenüberliegend angeordneten Fahrzeugeinstiegstüren 10 sowie ein Sanitärraum 12 des Fahrzeugs 2 abgebildet.

Der Sanitärraum 12 umfasst eine Schiebetür 14, über welche der Sanitärraum 12 betreten und verlassen werden kann. Im Sanitärraum 12 befinden sich eine Toilette 16, ein Handwaschbecken 18 sowie ein Händetrockner 20 mit Warmluftgebläse. Gegenüber der Schiebetür 14 des Sanitärraums 12 weist das Fahrzeug 2 einen Mülleimer 22 mit einer Mülleimerklappe 24 auf.

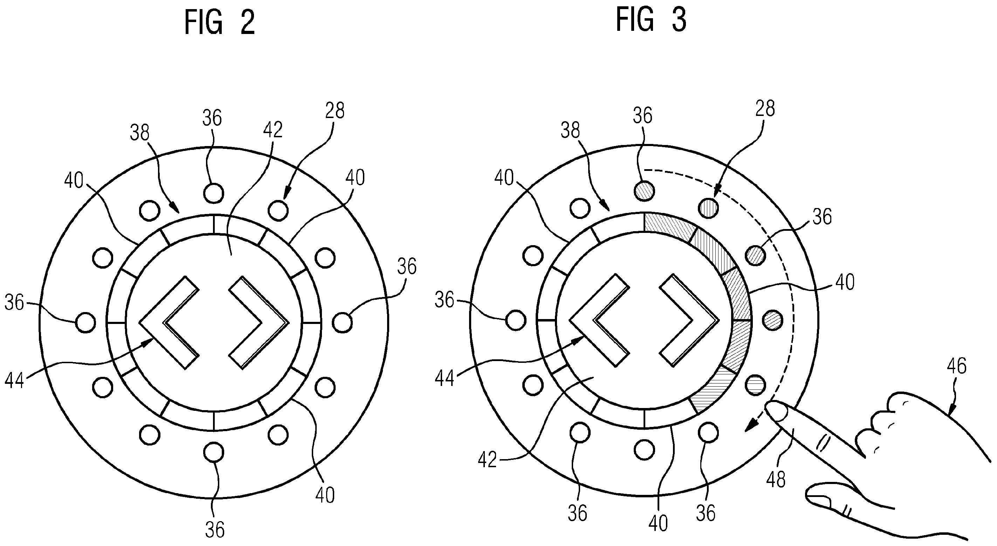

Des Weiteren ist das Fahrzeug 2 mit einer Mehrzahl von Betätigungsvorrichtungen 26a-26f ausgestattet, die jeweils über eine vorgegebene berührungslose Betätigungsgeste betätigbar sind. Die Betätigungsvorrichtungen 26a-26f umfassen jeweils eine Sensoreinheit 28 (vgl. FIG 2 und FIG 3) sowie eine mit der Sensoreinheit 28 verbundene, interne Auswerteeinheit 30. Zudem ist die jeweilige Betätigungsvorrichtung 26a-26f an einer Vorrichtung des Fahrzeugs 2 angeordnet, welche mittels der jeweiligen Betätigungsvorrichtung 26a-26f steuerbar ist.

Eine erste Betätigungsvorrichtung 26a der Mehrzahl von Betätigungsvorrichtungen 26a-26f ist zum berührungslosen Aktivieren einer Toilettenspülung 32 der Toilette 16 vorgesehen. Eine zweite Betätigungsvorrichtung 26b der Mehrzahl von Betätigungsvorrichtungen 26a-26f ist zum berührungslosen Aktivieren einer Auslaufarmatur 34 des Handwaschbeckens 18 vorgesehen. Ferner ist eine dritte Betätigungsvorrichtung 26c der Mehrzahl von Betätigungsvorrichtungen 26a-26f zum berührungslosen Aktivieren des Händetrockners 20 vorgesehen. Zwei weitere Betätigungsvorrichtungen 26d der Mehrzahl von Betätigungsvorrichtungen 26a-26f, von denen eine innen im Sanitärraum 12 angeordnet ist und die andere außen am Sanitärraum 12 angeordnet ist, dienen zum berührungslosen Aktivieren eines Türantriebs der Schiebetür 14 des Sanitärraums 12. Mithilfe der beiden letztgenannten Betätigungsvorrichtungen 26d kann die Schiebetür 14 des Sanitärraums 12 berührungslos geöffnet und geschlossen werden.

Eine andere Betätigungsvorrichtung 26e der Mehrzahl von Betätigungsvorrichtungen 26a-26f dient zum berührungslosen Aktivieren eines Klappenantriebs der Mülleimerklappe 24 des zuvor erwähnten Mülleimers 22. Mittels dieser Betätigungsvorrichtung 26e kann die Mülleimerklappe 24 berührungslos geöffnet und geschlossen werden.

Darüber hinaus dienen vier weitere Betätigungsvorrichtungen 26f der Mehrzahl von Betätigungsvorrichtungen 26a-26f zum berührungslosen Aktivieren eines Türantriebs der jeweiligen Fahrzeugeinstiegstür 10. Mithilfe dieser beiden Betätigungsvorrichtungen 26f können die besagten Fahrzeugeinstiegstüren 10 berührungslos geöffnet und geschlossen werden.

FIG 2 zeigt exemplarisch eine der Betätigungsvorrichtungen 26a-26f des Fahrzeugs 2 in einer Frontalansicht. Die nachfolgenden Ausführungen gelten analog für die anderen Betätigungsvorrichtungen 26a-26f des Fahrzeugs 2.

Wie zuvor erwähnt, ist die Betätigungsvorrichtung mit einer Sensoreinheit 28 ausgestattet. Diese umfasst mehrere berührungslos messende Sensoren 36, von denen jeder einen Erfassungsbereich aufweist, der sich bis zu einer Entfernung von 5 cm von der Betätigungsvorrichtung erstreckt und innerhalb dessen der jeweilige Sensor 36 berührungslos eine Bewegung eines Objekts erfassen kann. Gemeinsam bilden die Erfassungsbereiche der Sensoren 36 einen Erfassungsraum der Sensoreinheit 28, innerhalb dessen die Sensoreinheit 28 berührungslos eine Bewegung eines Objekts erfassen kann.

Die Sensoren 36 sind äquidistant zueinander positioniert und kreisförmig nebeneinander angeordnet. Im vorliegenden Ausführungsbeispiel handelt es sich bei den Sensoren 36 um Infrarotsensoren, wobei anstelle von Infrarotsensoren alternativ zum Beispiel kapazitive Sensoren zum Einsatz kommen können.

Des Weiteren umfasst die Betätigungsvorrichtung eine Visualisierungsvorrichtung 38, die mehrere Leuchtvorrichtungen 40 umfasst. Als Leuchtmittel können die Leuchtvorrichtungen 40 beispielsweise jeweils eine oder mehrere Leuchtdioden aufweisen. Die Leuchtvorrichtungen 40 sind als Ringsegmente ausgebildet und derart angeordnet, dass die Leuchtvorrichtungen 40 zusammen einen Ring ausbilden.

Jedem der Sensoren 36 der Sensoreinheit 28 ist genau eine Leuchtvorrichtung 40 der Visualisierungsvorrichtung 38 zugeordnet. Im vorliegenden Ausführungsbeispiel weist die Betätigungsvorrichtung zwölf Sensoren 36 sowie zwölf Leuchtvorrichtungen 40 auf, wobei grundsätzlich eine höhere oder niedrigere Anzahl von Sensoren 36 und eine höhere oder niedrigere Anzahl von Leuchtvorrichtung 40 vorgesehen sein können.

Mithilfe ihrer Sensoreinheit 28 und ihrer (in FIG 2 nicht dargestellten) Auswerteeinheit 30 ist die Betätigungsvorrichtung mittels einer vorgegebenen berührungslosen Betätigungsgeste betätigbar. Im vorliegenden Ausführungsbeispiel ist die Betätigungsvorrichtung über eine kreisförmige Betätigungsgeste betätigbar, welche wahlweise im Uhrzeigersinn oder im Gegenuhrzeigersinn ausgeführt werden kann, wobei der Startpunkt der Betätigungsgeste frei wählbar ist.

Die Sensoreinheit 28 ist dazu eingerichtet, ein Sensorsignal zu erzeugen und das Sensorsignal an die Auswerteeinheit 30 der Betätigungsvorrichtung zu übermitteln, wenn ein Objekt, wie zum Beispiel ein Finger einer Person, innerhalb eines Erfassungsraums der Sensoreinheit 28 eine Bewegung mit einem Abstand zur Betätigungsvorrichtung ausführt. Das Signal ist dabei vom Bewegungsablauf der Bewegung abhängig.

Die Auswerteeinheit 30 ist dazu eingerichtet, anhand des Sensorsignals zu prüfen, ob die vom Objekt ausgeführte Bewegung die vorgegebene berührungslose Betätigungsgeste ist, durch welche die Betätigungsvorrichtung betätigbar ist.

Entspricht die vom Objekt ausgeführte Bewegung der vorgegebenen berührungslosen Betätigungsgeste, durch welche die Betätigungsvorrichtung betätigbar ist, erzeugt die Auswerteeinheit 30 ein Steuersignal für die mittels der Betätigungsvorrichtung zu steuernde Vorrichtung des Fahrzeugs 2 und übermittelt das Steuersignal an die besagte Vorrichtung.

Zusätzlich weist die Betätigungsvorrichtung eine kreisförmige Taste 42 auf, mittels welcher die Betätigungsvorrichtung durch Druckausübung per Finger oder Handfläche (anstatt durch eine berührungslose Betätigungsgeste) betätigbar ist. Vorliegend ist die Taste 42 sowohl von den Leuchtvorrichtungen 40 der Visualisierungsvorrichtung 38 als auch von den Sensoren 36 der Sensoreinheit 28 umgeben.

Die Taste 42 ist mit einem erhabenen Piktogramm 44 versehen, welches die Funktion der Betätigungsvorrichtung bildlich wiedergibt. In FIG 2 umfasst das Piktogramm 44 exemplarisch eine nach links gerichtete Pfeilspitze sowie eine nach rechts gerichtete Pfeilspitze, wodurch symbolisiert wird, dass die Betätigungsvorrichtung aus FIG 2 zum Öffnen und/oder Schließen einer Tür dient. Falls die Betätigungsvorrichtung einem anderen Zweck dient, so weist ihre Taste 42 entsprechend ein anderes Piktogramm 44 auf.

FIG 3 zeigt die Betätigungsvorrichtung aus FIG 2 sowie eine Hand 46 einer Person.

Bewegt die Person einen Finger 48 der Hand 46 im Abstand zur Betätigungsvorrichtung durch den Erfassungsbereich des jeweiligen Sensors 36, wird vom jeweiligen Sensor 36 ein Durchtritt des Fingers 48 durch seinen Erfassungsbereich erfasst und ein Signal erzeugt. Das von der Sensoreinheit 28 erzeugte Sensorsignal, anhand dessen die Auswerteeinheit 30 prüft, ob die Bewegung des Fingers 48 der vorgegebenen berührungslosen Betätigungsgeste entspricht, basiert auf den von den einzelnen Sensoren 36 erzeugten Signalen.

In FIG 3 sind diejenigen Sensoren 36, durch deren Erfassungsbereiche der Finger 48 von der Person bereits geführt worden ist, schraffiert dargestellt. Um den bislang von der Sensoreinheit 28 erfassten Anteil der Bewegung des Fingers 48 zu visualisieren, lässt die Visualisierungsvorrichtung 38 diejenigen ihrer Leuchtvorrichtungen 40 leuchten, welche diesen Sensoren 36 zugeordnet sind. In FIG 3 sind diejenigen Leuchtvorrichtungen 40, die leuchten, schraffiert dargestellt.

Wird der Finger 48 durch die Erfassungsbereiche aller Sensoren 36 der Sensoreinheit 28 geführt, leuchten alle Leuchtvorrichtungen 40 der Visualisierungsvorrichtung 38 auf, sodass der Person visualisiert wird, dass die von der Person ausgeführte berührungslose Geste erfolgreich war, also die von der Person ausgeführte berührungslose Geste der vorgegebenen berührungslosen Betätigungsgeste entspricht, durch welche die Betätigungsvorrichtung betätigbar ist.

Gegebenenfalls kann die Auswerteeinheit 30 dazu eingerichtet sein, die Bewegung des Fingers 48 auch dann als vorgegebene berührungslose Betätigungsgeste einzustufen, durch welche die Betätigungsvorrichtung betätigbar ist, wenn nicht jeder der Sensoren 36 der Sensoreinheit 28 einen Durchtritt des Objekts durch seinen Erfassungsbereich detektiert, zum Beispiel weil einer der Sensoren 36 defekt ist oder die Person mit ihrem Finger 48 (unbeabsichtigterweise) einen oder mehrere Sensoren 36 nicht passiert hat.

Obwohl die Erfindung im Detail durch das bevorzugte Ausführungsbeispiel näher illustriert und beschrieben wurde, so ist die Erfindung nicht durch das offenbarte Beispiel eingeschränkt und andere Variationen können hieraus abgeleitet werden, ohne den Schutzumfang der Erfindung zu verlassen.

## Patentansprüche

1. Betätigungsvorrichtung (26a-26f) für ein Fahrzeug (2) des öffentlichen Personenverkehrs, welche durch eine vorgegebene berührungslose Betätigungsgeste betätigbar ist, aufweisend eine berührungslos messende Sensoreinheit (28) sowie eine mit der Sensoreinheit (28) verbundene Auswerteeinheit (30), wobei
- die Sensoreinheit (28) dazu eingerichtet ist, ein Sensorsignal zu erzeugen und das Sensorsignal an die Auswerteeinheit (30) zu übermitteln, wenn ein Objekt, insbesondere ein Finger (48) oder eine Hand einer Person, innerhalb eines Erfassungsraums der Sensoreinheit (28) eine Bewegung mit einem Abstand zur Betätigungsvorrichtung (26a-26f) ausführt, wobei das Signal vom Bewegungsablauf der Bewegung abhängig ist, wobei die Sensoreinheit (28) mehrere nebeneinander angeordnete, berührungslos messende Sensoren (36) umfasst, wobei jeder der Sensoren (36) einen eigenen Erfassungsbereich aufweist und sich der Erfassungsraum der Sensoreinheit (28) aus den Erfassungsbereichen der einzelnen Sensoren (36) zusammensetzt, und wobei
- die Auswerteeinheit (30) dazu eingerichtet ist, anhand des Sensorsignals zu prüfen, ob die vom Objekt ausgeführte Bewegung eine vorgegebene berührungslose Betätigungsgeste ist, durch welche die Betätigungsvorrichtung (26a-26f) betätigbar ist, und, falls die vom Objekt ausgeführte Bewegung eine solche Betätigungsgeste ist, ein Steuersignal für eine zu steuernde Vorrichtung (10, 14, 20, 24, 32, 34) des Fahrzeugs (2) zu erzeugen.

2. Betätigungsvorrichtung (26a-26f) nach Anspruch 1, **gekennzeichnet durch** ein Taste (42), mittels welcher die Betätigungsvorrichtung (26a-26f) durch Druckausübung betätigbar ist.

3. Betätigungsvorrichtung (26a-26f) nach Anspruch 1 oder 2, **dadurch gekennzeichnet, dass** der Erfassungsraum der Sensoreinheit (28) sich bis zu einer Entfernung von höchstens 10 cm, vorzugsweise höchstens 7 cm, besonders bevorzugt höchstens 5 cm, von der Betätigungsvorrichtung (26a-26f) erstreckt.

4. Betätigungsvorrichtung (26a-26f) nach einem der voranstehenden Ansprüche,
**dadurch gekennzeichnet, dass** die Auswerteeinheit (30) dazu eingerichtet ist, die Bewegung des Objekts auch dann als eine vorgegebene berührungslose Betätigungsgeste einzustufen, durch welche die Betätigungsvorrichtung (26a-26f) betätigbar ist, wenn nicht jeder der Sensoren (36) der Sensoreinheit (28) einen Durchtritt des Objekts durch seinen Erfassungsbereich detektiert.

5. Betätigungsvorrichtung (26a-26f) nach einem der voranstehenden Ansprüche,
**dadurch gekennzeichnet, dass** die Sensoren (36) kreisförmig nebeneinander angeordnet sind und die Betätigungsvorrichtung (26a-26f) über eine kreisförmige oder im Wesentlichen kreisförmige Betätigungsgeste betätigbar ist.

6. Betätigungsvorrichtung (26a-26f) nach einem der voranstehenden Ansprüche,
**dadurch gekennzeichnet, dass** die Sensoren (36) der Sensoreinheit (28) Infrarotsensoren sind.

7. Betätigungsvorrichtung (26a-26f) nach einem der voranstehenden Ansprüche,
**gekennzeichnet durch** eine mit der Sensoreinheit (28) verbundene Visualisierungsvorrichtung (38) zum Visualisieren des von der Sensoreinheit (28) erfassten Anteils der Bewegung des Objekts.

8. Betätigungsvorrichtung (26a-26f) nach Anspruch 7,
**dadurch gekennzeichnet, dass** die Visualisierungsvorrichtung (38) mehrere Leuchtvorrichtungen (40) umfasst und die Visualisierungsvorrichtung (38) dazu eingerichtet ist, die einzelnen Leuchtvorrichtungen (40) in Abhängigkeit vom Bewegungsablauf der Bewegung des Objekts aufleuchten zu lassen.

9. Betätigungsvorrichtung (26a-26f) nach Anspruch 7 oder 8, **dadurch gekennzeichnet, dass** jeder der Leuchtvorrichtungen (40) mindestens ein Sensor (36), insbesondere genau ein Sensor (36), der Sensoreinheit (28) zugeordnet ist und die Visualisierungsvorrichtung (38) dazu eingerichtet ist, die jeweilige Leuchtvorrichtung (40) aufleuchten zu lassen, wenn das Objekt durch den Erfassungsbereich eines der jeweiligen Leuchtvorrichtung (40) zugeordneten Sensors (36) geführt wird.

10. Fahrzeug (2) des öffentlichen Personenverkehrs, aufweisend eine oder mehrere Betätigungsvorrichtungen (26a-26f) nach einem der voranstehenden Ansprüche.

11. Verwendung einer Betätigungsvorrichtung (26a-26f) nach einem der Ansprüche 1 bis 9 in oder an einem Sanitärraum (12) eines Fahrzeugs (2) des öffentlichen Personenverkehrs, insbesondere zum Aktivieren einer Toilettenspülung (32), zum Aktivieren einer Auslaufarmatur (34) eines Handwaschbeckens (18), zum Aktivieren eines Händetrockners (20) oder zum Öffnen und/oder Schließen einer Tür (14) des Sanitärraums (12).

12. Verwendung einer Betätigungsvorrichtung (26a-26f) nach einem der Ansprüche 1 bis 9 in einem Fahrzeug (2) des öffentlichen Personenverkehrs zum Aktivieren eines Türantriebs zum Öffnen und/oder Schließen einer Fahrzeugeinstiegstür (10).

13. Verwendung einer Betätigungsvorrichtung (26a-26f) nach einem der Ansprüche 1 bis 9 in einem Fahrzeug (2) des öffentlichen Personenverkehrs zum Aktivieren eines Klappenantriebs zum Öffnen und/oder Schließen einer Mülleimerklappe (24).

14. Verwendung einer Betätigungsvorrichtung (26a-26f) nach einem der Ansprüche 1 bis 9 in einem Fahrzeug (2) des öffentlichen Personenverkehrs zum Signalisieren eines Haltewunschs.

## Claims

1. Actuation device (26a-26f) for a vehicle (2) for public passenger transportation, said actuation device being capable of being actuated by a predetermined contactless actuation gesture, exhibiting a sensor unit (28) measuring in contactless manner and also an evaluation unit (30) connected to the sensor unit (28), wherein
- the sensor unit (28) is configured to generate a sensor signal and to transmit the sensor signal to the evaluation unit (30) if an object, in particular a finger (48) or a hand of a person, executes a movement at a distance from the actuation device (26a-26f) within a detection space of the sensor unit (28), wherein the signal is dependent on the movement sequence of the movement, wherein the sensor unit (28) comprises a plurality of contactlessly measuring sensors (36) arranged next to one another, wherein each of the sensors (36) has its own detection range and the detection space of the sensor unit (28) is composed of the detection ranges of the individual sensors (36), and wherein
- the evaluation unit (30) has been set up to check, on the basis of the sensor signal, whether the movement executed by the object is a predetermined contactless actuation gesture by which the actuation device (26a-26f) is capable of being actuated, and, if the movement executed by the object is such an actuation gesture, to generate a control signal for a device (10, 14, 20, 24, 32, 34) of the vehicle (2) to be controlled.

2. Actuation device (26a-26f) according to Claim 1,
**characterized by** a button (42) by means of which the actuation device (26a-26f) is capable of being actuated by exertion of pressure.

3. Actuation device (26a-26f) according to Claim 1 or 2,
**characterized in that** the detection space of the sensor unit (28) extends up to a distance of at most 10 cm, preferentially at most 7 cm, particularly preferably at most 5 cm, from the actuation device (26a-26f).

4. Actuation device (26a-26f) according to one of the preceding claims,
**characterized in that** the evaluation unit (30) has been set up to classify the movement of the object as a predetermined contactless actuation gesture by which the actuation device (26a-26f) is capable of being actuated even when not every one of the sensors (36) of the sensor unit (28) detects a passage of the object through its detection zone.

5. Actuation device (26a-26f) according to one of the preceding claims,
**characterized in that** the sensors (36) are juxtaposed in the form of a circle and the actuation device (26a-26f) is capable of being actuated via a circular or substantially circular actuation gesture.

6. Actuation device (26a-26f) according to one of the preceding claims,
**characterized in that** the sensors (36) of the sensor unit (28) are infrared sensors.

7. Actuation device (26a-26f) according to one of the preceding claims,
**characterized by** a visualization device (38), connected to the sensor unit (28), for visualizing the portion of the movement of the object detected by the sensor unit (28).

8. Actuation device (26a-26f) according to Claim 7,
**characterized in that** the visualization device (38) comprises several luminous devices (40), and the visualization device (38) has been set up to cause the individual luminous devices (40) to light up as a function of the movement sequence of the movement of the object.

9. Actuation device (26a-26f) according to Claim 7 or 8,
**characterized in that** at least one sensor (36), in particular precisely one sensor (36), of the sensor unit (28) has been assigned to each of the luminous devices (40), and the visualization device (38) has been set up to cause the respective luminous device (40) to light up when the object is being guided through the detection zone of a sensor (36) assigned to the respective luminous device (40).

10. Vehicle (2) for public passenger transportation, exhibiting one or more actuation devices (26a-26f) according to one of the preceding claims.

11. Use of an actuation device (26a-26f) according to one of Claims 1 to 9 in or on a sanitary room (12) of a vehicle (2) for public passenger transportation, in particular for activating a toilet flushing mechanism (32), for activating an outflow fitting (34) of a washbasin (18), for activating a hand dryer (20) or for opening and/or closing a door (14) of the sanitary room (12).

12. Use of an actuation device (26a-26f) according to one of Claims 1 to 9 in a vehicle (2) for public passenger transportation, for activating a door drive for opening and/or closing a vehicle entry door (10).

13. Use of an actuation device (26a-26f) according to one of Claims 1 to 9 in a vehicle (2) for public passenger transportation, for activating a flap drive for opening and/or closing a rubbish-bin flap (24).

14. Use of an actuation device (26a-26f) according to one of Claims 1 to 9 in a vehicle (2) for public passenger transportation, for signalling a stop-request.

## Revendications

1. Dispositif d'actionnement (26a-26f) pour un véhicule (2) des transports publics, lequel peut être actionné par un geste d'actionnement sans contact prédéfini, comprenant une unité de capteur (28) à mesure sans contact ainsi qu'une unité d'évaluation (30) connectée à l'unité de capteur (28), dans lequel
- l'unité de capteur (28) est conçue pour générer un signal de capteur et transmettre le signal de capteur à l'unité d'évaluation (30), lorsqu'un objet, en particulier un doigt (48) ou une main d'une personne, exécute un mouvement à une distance du dispositif d'actionnement (26a-26f) dans un espace de détection de l'unité de capteur (28), le signal étant dépendant de la séquence de mouvement du mouvement, l'unité de capteur (28) comprenant plusieurs capteurs (36) à mesure sans contact agencés côte à côte, chaque capteur (36) ayant sa propre zone de détection et l'espace de détection de l'unité de capteur (28) étant composé des zones de détection des capteurs (36) individuels, et dans lequel
- l'unité d'évaluation (30) est conçue pour vérifier, à l'aide du signal de capteur, si le mouvement exécuté par l'objet est un geste d'actionnement sans contact prédéfini, par lequel le dispositif d'actionnement (26a-26f) peut être actionné, et, si le mouvement exécuté par l'objet est un tel geste d'actionnement, pour générer un signal de commande pour un dispositif à commander (10, 14, 20, 24, 32, 34) du véhicule (2).

2. Dispositif d'actionnement (26a-26f) selon la revendication 1,
**caractérisé par** une touche (42) au moyen de laquelle le dispositif d'actionnement (26a-26f) peut être actionné par application d'une pression.

3. Dispositif d'actionnement (26a-26f) selon la revendication 1 ou 2,
**caractérisé en ce que** l'espace de détection de l'unité de capteur (28) s'étend jusqu'à une distance d'au plus 10 cm, de préférence d'au plus 7 cm, de manière particulièrement préférée, d'au plus 5 cm, du dispositif d'actionnement (26a-26f).

4. Dispositif d'actionnement (26a-26f) selon l'une des revendications précédentes,
**caractérisé en ce que** l'unité d'évaluation (30) est conçue pour classer le mouvement de l'objet comme étant un geste d'actionnement sans contact prédéfini, par lequel le dispositif d'actionnement (26a-26f) peut être actionné, même si tous les capteurs (36) de l'unité de capteur (28) ne détectent pas de passage de l'objet à travers leur zone de détection.

5. Dispositif d'actionnement (26a-26f) selon l'une des revendications précédentes,
**caractérisé en ce que** les capteurs (36) sont agencés côte à côte de manière circulaire et le dispositif d'actionnement (26a-26f) peut être actionné par un geste d'actionnement circulaire ou sensiblement circulaire.

6. Dispositif d'actionnement (26a-26f) selon l'une des revendications précédentes,
**caractérisé en ce que** les capteurs (36) de l'unité de capteur (28) sont des capteurs infrarouges.

7. Dispositif d'actionnement (26a-26f) selon l'une des revendications précédentes,
**caractérisé par** un dispositif de visualisation (38) connecté à l'unité de capteur (28) pour visualiser la partie du mouvement de l'objet qui est détectée par l'unité de capteur (28).

8. Dispositif d'actionnement (26a-26f) selon la revendication 7,
**caractérisé en ce que** le dispositif de visualisation (38) comprend plusieurs dispositifs lumineux (40) et le dispositif de visualisation (38) est conçu pour allumer les dispositifs lumineux (40) individuels en fonction du déroulement du mouvement de l'objet.

9. Dispositif d'actionnement (26a-26f) selon la revendication 7 ou 8,
**caractérisé en ce que** chacun des dispositifs lumineux (40) est associé à au moins un capteur (36), notamment exactement un capteur (36), de l'unité de capteur (28) et le dispositif de visualisation (38) est conçu pour allumer le dispositif lumineux (40) respectif lorsque l'objet est guidé à travers la zone de détection d'un capteur (36) associé au dispositif lumineux (40) respectif.

10. Véhicule (2) des transports publics, comprenant un ou plusieurs dispositifs d'actionnement (26a-26f) selon l'une des revendications précédentes.

11. Utilisation d'un dispositif d'actionnement (26a-26f) selon l'une des revendications 1 à 9 dans ou sur un espace sanitaire (12) d'un véhicule (2) des transports publics, en particulier pour activer une chasse d'eau (32), pour activer un robinet de sortie (34) d'un lavabo (18), pour activer un sèche-mains (20) ou pour ouvrir et/ou fermer une porte (14) de l'espace sanitaire (12).

12. Utilisation d'un dispositif d'actionnement (26a-26f) selon l'une des revendications 1 à 9 dans un véhicule (2) des transports publics pour activer un entraînement de porte afin d'ouvrir et/ou de fermer une porte d'accès au véhicule (10).

13. Utilisation d'un dispositif d'actionnement (26a-26f) selon l'une des revendications 1 à 9 dans un véhicule (2) des transports publics pour activer un entraînement de clapet afin d'ouvrir et/ou de fermer un clapet de poubelle (24).

14. Utilisation d'un dispositif d'actionnement (26a-26f) selon l'une des revendications 1 à 9 dans un véhicule (2) des transports publics pour signaler une demande d'arrêt.
